Europäisches Patentamt

European Patent Office

Office européen des brevets

(19)

(11) Veröffentlichungsnummer : **0 372 645 B1**

(12) # EUROPÄISCHE PATENTSCHRIFT

(45) Veröffentlichungstag der Patentschrift :
**26.07.95 Patentblatt 95/30**

(51) Int. Cl.$^6$ : **G03F 1/14**

(21) Anmeldenummer : **89203065.1**

(22) Anmeldetag : **04.12.89**

(54) **Verfahren zur Herstellung eines Maskenträgers aus SiC für Strahlungslithographie-Masken.**

(30) Priorität : **08.12.88 DE 3841352**

(43) Veröffentlichungstag der Anmeldung :
**13.06.90 Patentblatt 90/24**

(45) Bekanntmachung des Hinweises auf die
Patenterteilung :
**26.07.95 Patentblatt 95/30**

(84) Benannte Vertragsstaaten :
**DE FR GB IT NL**

(56) Entgegenhaltungen :
**EP-A- 0 244 496
EP-A- 0 310 183
GB-A- 2 100 713
IEEE ELECTRON DEVICE LETTERS, vol.
EDL-7, no. 12, Dezember 1986, New York, US,
Seiten 692-693 ; K. SHIBAHARA et al. :
"Fabrication of inversion-type n-channel
MOSFET's using cubic-SiC on Si(100)"
Proceedings of SPIE-The International Society
for Optical Engineering, vol. 923, Seiten 9-15,
Electron-Beam, X-Ray and Ion-Beam Technology : Submicrometer Lithographies VII, 2-4
March 1988, Santa Clara, CA, USA ; U.
MACKENS et al. : "Application of Sic-X-Ray
masks for fabricating sub-micron devices"**

(56) Entgegenhaltungen :
**IBM TECHNICAL DISCLOSURE BULLETIN,
vol. 31, no. 7, Dezember 1988, New York, US,
Seite 288, "Fabricating Boron-doped silicon
membranes"**

(73) Patentinhaber : **Philips Patentverwaltung
GmbH
Wendenstrasse 35c
D-20097 Hamburg (DE)**
(84) **DE**
Patentinhaber : **Philips Electronics N.V.
Groenewoudseweg 1
NL-5621 BA Eindhoven (NL)**
(84) **FR GB IT NL**

(72) Erfinder : **Harms, Margret
Max-Zelck-Strasse 14
D-2000 Hamburg 61 (DE)**
Erfinder : **Lüthje, Holger, Dipl.-Ing.
Buchenweg 15
D-2083 Halstenbek (DE)**
Erfinder : **Matthiessen, Bernd, Dipl.-Ing.
Am Felde 99
D-2000 Hamburg 50 (DE)**

(74) Vertreter : **Volmer, Georg, Dipl.-Ing. et al
Philips Patentverwaltung GmbH,
Wendenstrasse 35c
D-20097 Hamburg (DE)**

EP 0 372 645 B1

## Beschreibung

Die Erfindung betrifft ein Verfahren zur Herstellung eines Maskenträgers (Membran) aus SiC für Strahlungslithographie-Masken, wobei eine SiC-Schicht mindestens auf einer der beiden Hauptflächen eines Substrates in Form einer Silicium-Einkristallscheibe abgeschieden und die Silicium-Einkristallscheibe bis auf einen Randbereich mittels eines selektiven Ätzschrittes entfernt wird.

Mit der Arbeit von E. Spiller und R. Feder "X-ray lithography" in "Topics in current physics: X-ray optics", Springer, New York, 1977, Seiten 35 bis 92, wird gezeigt, welche Bedeutung die Strahlungslithographie bei der Herstellung von z.B. Halbleitersystemen oder magnetischen Zylinderdomänen-Anordnungen hat, da insbesondere bei diesen Fertigungsprozessen zunehmend immer kleiner werdende Strukturen im μm- oder nm-Bereich Bedeutung erlangen. Für alle Verfahren mit hoher Auflösung sind genaue und äußerst präzise definierte Masken erforderlich. Die Leistungsfähigkeit der Strahlungslithographie wird deutlich an der minimalen Streifenbreite der Strukturen, die mit ihr zu erreichen ist: Lichtlithographie etwa 2 bis 3 μm, Elektronenstrahllithographie etwa 0,05 bis 0,1 μm, Röntgenstrahllithographie kleiner 500 nm.

Der nach dem Verfahren der vorliegenden Erfindung hergestellte Maskenträger ist ganz allgemein für alle Arten von Strahlungslithographie Masken geeignet; die Beschreibung des Anforderungsprofils für eine solche Maske wird im folgenden im Hinblick auf die Röntgenstrahllithographie vorgenommen.

Die Anwendung von z.B. Röntgenstrahlen zur Belichtung eines zu strukturierenden Photolackes bringt den Vorteil, daß störende Beugungserscheinungen bei der Projektion der Maskenstrukturen auf die Lackschicht herabgesetzt werden.

Für die Belichtung mit Röntgenstrahlen sind spezielle Bestrahlungsmasken zur Strukturerzeugung im Lack erforderlich; eine solche Maske besteht aus dem Muster der herzustellenden Struktur aus einem stark Röntgenstrahlen absorbierenden Material (Absorber), wobei das Absorbermuster auf einem dünnen Maskenträger, der Membran, aus einem für Röntgenstrahlen möglichst hoch transparenten Material angebracht ist. Für den Absorber kommen Materialien mit einem möglichst hohen Atomgewicht in Betracht; in der Praxis bewährt haben sich z.B. Gold oder Wolfram. Als Material für die Membran kommen mehr oder weniger praktisch alle Materialien in Betracht, die hinlänglich transparent für Röntgenstrahlen sind.

Da im Falle der Röntgenstrahllithographie eine relativ weiche Strahlung ($\lambda$ = 0,5 bis 2 nm) zur Anwendung kommt, müssen Röntgenstrahllithographie-Masken aus relativ dünnen Membranen aufgebaut werden, die die in Submikrometerabmessungen erzeugten Absorberstrukturen tragen. Durch geeignete Wahl der Materialien und der Herstellungsprozesse muß einerseits sichergestellt werden, daß die Masken sowohl hinsichtlich der Röntgenstrahlung als auch hinsichtlich der zur Justierung erforderlichen Strahlung aus dem sichtbaren Bereich des Spektrums hinreichend transparent sind. Die dadurch limitierte Membrandicke liegt im Bereich von wenigen Mikrometern. Andererseits müssen die Masken zur Strukturvervielfältigung einen ausreichenden Kontrast aufweisen.

Da auch schwere Elemente, aus denen die Absorberstrukturen gebildet werden, gegenüber Röntgenstrahlung keinesfalls völlig opak sind, müssen die Absorberstrukturen im allgemeinen in einer Dicke von nahezu 1 μm appliziert werden. Diese Bedingungen zu realisieren, stellt die Fertigungstechnik bereits vor nicht unerhebliche Schwierigkeiten.

Die zunehmend kleiner werdenden Strukturen von Bauelementen, die mittels Röntgenstrahllithographie hergestellt werden, erfordern darüberhinaus Masken, deren Maßgenauigkeit in nur noch sehr engen Toleranzgrenzen (kleiner = 100 nm) schwanken dürfen. Damit steht die Fertigungstechnik vor erheblichen Problemen, denn diese engen Toleranzgrenzen müssen trotz vieler sehr unterschiedlicher Prozeßschritte für die Herstellung der Masken und auch über eine lange Lebensdauer der Masken mit bis zu $10^6$ Belichtungen pro Maske mit intensiver Röntgenbestrahlung erhalten bleiben. Diese Anforderungen lassen den hohen Stellenwert erkennen, der der mechanischen Stabilität der Membran zukommt. Da die mechanische Stabilität einer Membran durch deren Elastizitätsmodul charakterisiert werden kann, ist dieser Wert neben anderen Eigenschaften in der nachfolgenden Tabelle 1 für die wichtigsten bekannten Membran-Materialien dargestellt.

## Tabelle 1

| Material | thermische Ausdehnung $[K^{-1}]$ | Elastizi-tätsmodul $[N/m^2]$ | Brechungs-index | Dichte $[g/cm^3]$ |
|---|---|---|---|---|
| SiC | $4,7.10^{-6}$ | $4,57.10^{11}$ | 2,48 | 3,2 |
| Si | $2,6.10^{-6}$ | $1,62.10^{11}$ | 3,9 | 2,42 |
| $Si_3N_4$ | $2,7.10^{-6}$ | $1,55.10^{11}$ | 2,2 | – |
| BN | $1\ .10^{-6}$ | $1,33.10^{11}$ | 2,0 | 2,34 |
| Be | $12,3.10^{-6}$ | $3,02.10^{11}$ | – | 1,85 |
| Mg | $26\ .10^{-6}$ | $0,45.10^{11}$ | – | 1,74 |
| Ti | $9\ .10^{-6}$ | $1,1\ .10^{11}$ | – | 4,52 |

Aus der Tabelle geht hervor, daß SiC wegen seines hohen Elastizitätsmoduls, aber auch wegen seiner optischen Eigenschaften ein besonders geeignetes Material für Membranen für Röntgenstrahllithographie-Masken ist.

Neben der erforderlichen mechanischen Steifigkeit spielen außerdem auch die Topographie (Oberflächenrauhigkeit oder Rauhtiefe) und induzierte Spannungen eine wesentliche Rolle.

Aus der DE-A-3733311 ist ein Verfahren zur Herstellung eines Maskenträgers aus SiC für Röntgenstrahllithographie-Masken bekannt, mit dem glatte und relativ spannungsarme SiC-Membranen hergestellt werden können, die im Bereich des sichtbaren Lichtes auch eine ausreichende Transparenz aufweisen. Gemäß diesem bekannten Verfahren erfolgt die SiC-Schichtherstellung mit Hilfe eines optimierten Chemical Vapour Deposition-Prozesses in der Weise, daß eine verhältnismäßig glatte, jedoch mit hoher Spannung beaufschlagte SiC-Schicht auf ein Silicium-Einkristallsubstrat aufgebracht und die Spannung in einem weiteren Verfahrensschritt mittels implantierter Ionen in gewünschter Weise reduziert wird. Dieser Prozeß kann, abhängig von der gewählten Ionenart und ihrer Dosis, zu einer Verschlechterung der optischen Transparenz führen.

Der Erfindung liegt die Aufgabe zugrunde, das eingangs genannte Verfahren so zu verbessern, daß SiC-Membranen mit einem weniger arbeitsaufwendigen Verfahren hergestellt werden können, welche gegenüber den nach dem eingangs genannten Verfahren hergestellten SiC-Membranen spannungsärmer und im Bereich des sichtbaren Spektrums eine höhere Transparenz aufweisen.

Diese Aufgabe wird erfindungsgemäß dadurch gelöst, daß der Maskenträger vor oder nach dem selektiven Ätzschritt in oxidierender Atmosphäre bei einer Temperatur im Bereich von 200 bis 1350 °C über eine Dauer von 2 bis 10 h getempert wird.

Nach einer vorteilhaften Weiterbildung des Verfahrens gemäß der Erfindung wird der Maskenträger unter Sauerstoff-Atmosphäre bei einer Temperatur von 1100 °C über eine Dauer von 4 h getempert.

Bei Versuchen, die zur Erfindung geführt haben, hat sich überraschenderweise gezeigt, daß durch eine Temperung in oxidierender Atmosphäre und durch die damit verbundene Abscheidung einer Oxidschicht auf der SiC-Schicht die Spannung in der SiC-Schicht in gewünschter Weise reproduzierbar reduziert und die Transparenz für Strahlung aus dem sichtbaren Teil des Spektrums gleichzeitig beträchtlich erhöht werden kann.

Bei Rauhigkeitsmessungen wurde deutlich, daß die Oxidation der Oberfläche der SiC-Schicht auch zu einer Verringerung der Oberflächenrauhigkeit (Rauhtiefe) der SiC-Schicht führt, was insbesondere im Hinblick auf die Erkennung von Justierfiguren mittels sichtbarem Licht von Vorteil ist; durch die Oxidschicht wird die Reflexion der SiC-Schicht, die eine Folge des relativ hohen Brechungsindex von SiC ist, vermindert, denn die Oxidschicht wirkt als Antireflexbeschichtung. Als vorteilhaft hat sich die Ausbildung einer Oxidschicht auf der SiC-Schicht auch im Hinblick auf die spätere Erzeugung von Absorbermustern auf der aus der SiC-Schicht gebildeten Membran erwiesen, die eine Streifenbreite kleiner 0,5 μm aufweisen; bei diesen geringen Streifenbreiten wirken sich Oberflächenrauhigkeiten der Membran bereits sehr nachteilig aus.

Nach einer weiteren vorteilhaften Ausgestaltung des Verfahrens nach der Erfindung wird der Temperprozeß nur in ausgewählten Bereichen der SiC-Schicht mittels Erhitzung dieser Bereiche durch Laserstrahlung unter oxidierender Atmosphäre durchgeführt.

Dieses Vorgehen ist z.B. dazu geeignet, den Bereich der SiC-Schicht, auf welchem später Justierfiguren ausgebildet werden sollen, hinsichtlich seiner optischen Eigenschaften zu optimieren.

Nach einer bevorzugten Ausführungsform des Verfahrens gemäß der Erfindung wird auf der Silicium-Einkristallscheibe unter Einwirkung eines Kohlenwasserstoffgases eine SiC-Keimschicht erzeugt. Hiermit ist der Vorteil verbunden, daß eine homogenere Ausrichtung der SiC-Kristallite der anschließend aufgebrachten SiC-Schicht in Vorzugsrichtung erreicht wird. Hierdurch werden die optischen und die topographischen Eigenschaften der SiC-Schicht verbessert.

Nach einer weiteren vorteilhaften Ausgestaltung des erfindungsgemäßen Verfahren werden in die SiC-Schicht vordem Tempern Ionen implantiert zur mechanischen Störung der Kristallstruktur der SiC-Schicht. Auch im Zusammenwirken einer SiC-Schicht, in die Ionen zur Gitterstörung implantiert wurden, mit einer anschließend auf ihr ausgebildeten Oxidschicht ergeben sich Vorteile hinsichtlich des Spannungsverhaltens und der optischen Transparenz. Mit dem aus der DE-A-3733311 bekannten Verfahren werden SiC-Schichten hoher Zugspannung im Bereich von $x.10^8 N/m^2$ und geringer Rauhtiefe im nm-Bereich erreicht.

Durch die Implantation von Ionen, die die Kristallstruktur der abgeschiedenen SiC-Schicht stören, können die Zugspannungswerte in einem Bereich von $x.10^7 N/m^2$ eingestellt werden. Für die Transparenz dieser Schichten für Strahlung im Wellenlängenbereich zwischen 633 und 800 nm wurden Werte bis zu 32 % gemessen. Werden auf diese Weise hergestellte SiC-Schichten nun außerdem durch thermische Oxidation (durch Temperung in z.B. Sauerstoff-Atmosphäre) mit einer Oxidschicht versehen, können die Werte für die Transparenz für Strahlung aus dem Wellenlängenbereich zwischen 633 und 800 nm bis auf 70 % gesteigert werden.

Mit dem vorliegenden Verfahren der thermischen Oxidation von SiC-Schichten, die als Membran für Strahlungslithographie-Masken eingesetzt werden sollen, sind also folgende Vorteile verbunden:

Es kann eine Verminderung der kurzwelligen Rauhigkeit der Oberfläche der SiC-Schicht erreicht werden, was von Vorteil nicht nur für die Erkennung von auf der oxidierten SiC-Schicht ausgebildeten Justierfiguren ist, sondern was auch die Herstellung von Absorberstrukturen besonders kleiner Streifenbreite im Bereich unter 0,5 μm begünstigt; die optische Transparenz im Wellenlängenbereich zwischen 633 und 800 nm einer SiC-Schicht kann, abhängig von der Schichtdicke, durch eine Oxidation deutlich verbessert werden;
ebenfalls kann die Zugspannung in einer durch insbesondere Chemical Vapour Deposition (CVD) hergestellten SiC-Schicht verringert werden.

Nähere Einzelheiten und Vorteile des vorliegenden Verfahrens werden anhand des nachfolgend beschriebenen Ausführungsbeispiels verdeutlicht.

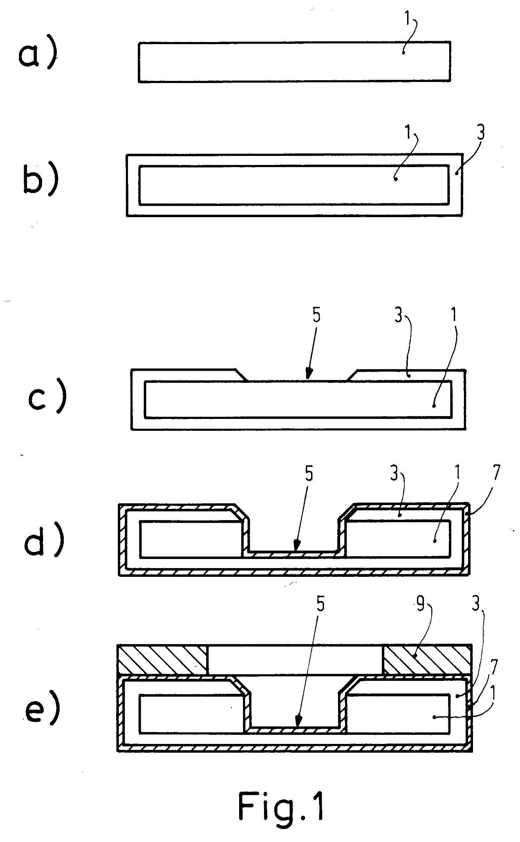

Die Zeichnung zeigt mit Figur 1 eine schematische Darstellung des Prozeßablaufes der Beschichtung eines Substrates mit einer SiC-Schicht, Ausbilden einer SiC-Membran nach Entfernen eines Teils des Substrates und Ausbildung einer Oxidschicht auf der SiC-Membran durch thermische Oxidation.

Als Substrat 1 dient eine handelsübliche Silicium-Einkristallscheibe mit [100]-Orientierung, auf der allseitig eine etwa 2,5 μm dicke SiC-Schicht 3 abgeschieden wird (Figuren 1a, 1b). Statt einer in [100]-Richtung orientierten Silicium-Einkristallscheibe kann auch eine in [111]-Richtung orientierte Silicium-Einkristallscheibe eingesetzt werden. Der gewünschte Membranbereich 5 wird durch eine mechanische Maske (nicht dargestellt) definiert und die SiC-Schicht 3 wird, beispielsweise durch reaktives Ionenätzen in $SF_6$-Atmosphäre, in diesem Bereich entfernt (Figur 1c). Das Substrat 1 wird dann in einem selektiv wirkenden Ätzmittel, beispielsweise KOH, naßchemisch im Membranbereich 5 entfernt. Anschließend wird durch Tempern in oxidierender Atmosphäre (thermische Oxidation) eine Oxidschicht 7 auf der Oberfläche der SiC-Schicht 3 erzeugt (Figur 1d). Die Fertigstellung des Maskenträgers erfolgt durch Aufkleben des ausgeätzten Substrates 1 mit den auf ihm angebrachten Schichten 3 und 7 auf einem z.B. 5 mm dicken Glasring 9 (Figur 1e).

Da die Qualität des Maskenträgers (Membran) im wesentlichen durch den Beschichtungsprozeß beeinflußt wird, kommt der SiC-Abscheidung eine besondere Bedeutung zu. Neben der erwünschten mechanischen Steifigkeit sind weitere, für die Anwendung als Membran essentielle Kriterien die Spannung und die Rauhtiefe der SiC-Schicht. Es zeigte sich, daß die Schichteigenschaften bei Abscheidung aus der Gasphase bei ausreichender Konzentration von Silicium und Kohlenwasserstoffen im Reaktionsgas (z.B. Dichlordimethylsilan $(CH_3)_2SiCl_2$ und Propan $C_3H_8$ in $H_2$ als Trägergas) nicht unerheblich durch die Beschichtungstemperatur und die am Prozeß beteiligte Menge an Kohlenwasserstoff, die als Kohlenstoffquelle dient, beeinflußt werden können. Mit steigender Temperatur erfolgt eine Verringerung der Zugspannung in Richtung auf eine gegenläufige Druckspannung. Allgemein verschiebt sich die Temperatur zur Erzielung spannungsarmer SiC-Schichten mit zunehmendem Propangehalt in tiefere Bereiche.

Vergleichbare Ergebnisse wurden auch mit Silan $SiH_4$ und Toluol $C_7H_8$ bzw. mit Silan $SiH_4$ und Propan $C_3H_8$ gewonnen. Eine Analyse von Schichten läßt einheitlich auf eine polykristalline Struktur schließen, die im wesentlichen β-orientiert ist. Die Wasserstoff- wie auch die Chlorkonzentration lag in allen Fällen unter 3 Atom%, unabhängig vom Kohlenwasserstoffgehalt des Reaktionsgases.Der Elastizitätsmodul wurde zu $4,6.10^{11}N/m^2$ bestimmt. Hinsichtlich der optischen Transparenz wurden im Wellenlängenbereich zwischen 700 und 800 nm an 2,5 µm dicken SiC-Schichten Werte von mehr als 50 % gemessen, die nach Ausbilden der Oxidschicht auf der SiC-Schicht auf mehr als 70 % angehoben werden können.

Da der polykristallinen Struktur der SiC-Schicht eine Oberflächenrauhigkeit (Rauhtiefe) immanent ist, wurde auch diese Eigenschaft ausführlich untersucht. Die mechanisch mit Hilfe eines Abtastsystems ermittelten Werte für die Rauhtiefe ($R_t$) werden ebenfalls erheblich beeinflußt durch die Reaktionstemperatur und den Kohlenwasserstoffgehalt bei der Herstellung der SiC-Schicht. Da eine Optimierung des Herstellungsprozesses für die Membran sowohl im Hinblick auf eine möglichst geringe Zugspannung (σ etwa $5.10^7N/m^2$) als auch auf eine möglichst geringe Rauhtiefe ($R_t$ kleiner 30 nm) erfolgen sollte, muß ein Kompromiß gesucht werden, denn es lassen sich entweder nur relativ rauhe Schichten ($R_t$ etwa 100 nm), die die Justier- und die Strukturqualität der Maske erheblich limitieren, oder aber glatte Schichten ($R_t$ etwa 10 nm) mit höherer Zugspannung (σ etwa $4.10^8N/m^2$) herstellen.

Um zu erreichen, daß sowohl relativ glatte als auch relativ spannungsfreie SiC-Schichten mit einem kostengünstigen Prozeß hergestellt werden können, wird die erfindungsgemäße Membran in zwei Prozeßschritten hergestellt, wobei im ersten Schritt eine SiC-Schicht 3 mit höherer Zugspannung und bereits relativ geringer Rauhtiefe auf dem Silicium-Einkristallsubstrat 1 abgeschieden wird, auf der im zweiten Schritt des Verfahrens, vorzugsweise nach Ausätzen eines Teils des Substrates 1 im Membranbereich 5,mit Hilfe eines Temperpozesses in oxidierender Atmosphäre eine Oxidschicht ausgebildet wird. Durch diesen Oxidationsschritt wird nicht nur eine Verringerung der Spannung innerhalb der SiC-Schicht 3 erreicht sondern auch eine weitere Verringerung der Rauhtiefe der SiC-Schicht 3, wobei die Werte für die optische Transparenz im Wellenlängenbereich von 600 bis 1000 nm, insbesondere 633 bis 800 nm, ebenfalls verbessert sind. Hierzu wird auf Tabelle 2 verwiesen.

Zur Herstellung einer 2,5 µm dicken SiC-Schicht 3 mit einer anschließend aufgebrachten etwa 110 nm dicken Oxidschicht 7 werden folgende Bedingungen angewandt:

1. Aufheizen des Substrates in Form einer [100]- oder [111]-orientierten Silicium-Einkristallscheibe auf eine Temperatur von 1110 °C unter $H_2$-Atmosphäre,

2. Anätzen des Substrates in HCl über eine Dauer von 4 min,

3. Spülen des angeätzten Substrates in $H_2$ über eine Dauer von 4 min,

4. SiC-Abscheidung aus einem Reaktionsgas mit 1,4 % Dichlordimethylsilan $(CH_3)_2SiCl_2$ in $H_2$-Trägergas, zuzüglich 15 % Propan $C_3H_8$, bezogen auf Dichlordimethylsilan; Abscheidedauer 60 s,

5. Abkühlen unter $H_2$-Atmosphäre auf Raumtemperatur.

Die auf diese Weise hergestellte SiC-Schicht 3 besitzt eine Rauhtiefe $R_t$ kleiner 45 nm. Die über die Substratverformung ermittelte Zugspannung beträgt etwa $2,5$ bis $5.10^8N/m^2$. Die optische Transparenz im Wellenlängenbereich von 633 bis 800 nm liegt im Bereich von etwa 38 bis etwa 70 %.

Anschließend wird die auf dem Substrat 1 angebrachte SiC-Schicht 3 einem Temperprozeß in oxidierender Atmosphäre unterzogen. Hierzu wird das mit der SiC-Schicht 3 versehene Substrat 1 auf eine Temperatur im Bereich von 1000 bis 1350 °C, vorzugsweise 1100 °C, in einem Ofen aufgeheizt, in den als oxidierendes Gas Sauerstoff eingeleitet wird. Nach Erreichen der gewünschten Tempertemperatur wird diese Temperatur über eine Dauer von 2 bis 4 h, vorzugsweise 4 h, gehalten und danach wird auf Raumtemperatur abgekühlt.

Aus der nachfolgenden Tabelle 2 wird deutlich, wie eine thermische Oxidation bei unterschiedlichen Tempertemperaturen im Bereich von 900 bis 1100 °C und unterschiedlicher Dauer des Temperprozesses im Bereich von 4 bis 8 h die Werte für die optische Transparenz, die Spannung und die Rauhtiefe einer SiC-Membran beeinflußt.

Tabelle 2: Thermische Oxidation von SiC-Membranen

| Probe Nr. | Temperung | | | Eigenschaften vor der Temperung | | | | Eigenschaften nach der Temperung | | | |
|---|---|---|---|---|---|---|---|---|---|---|---|
| | Dauer [h] | Temp. [°C] | Atmosphäre | Transparenz [%] λ=633 nm | Transparenz [%] λ=800 nm | Spannung [x $10^8$ N/m²] | Rauhtiefe [nm] | Transparenz [%] λ=633 nm | Transparenz [%] λ=800 nm | Spannung [x $10^8$ N/m²] | Rauhtiefe [nm] |
| 1 | 4 | 900 | $O_2$ | 38 | 56 | 2,69 | – | 43 | 66 | 2,35 | – |
| 2 | 8 | 900 | $O_2$ | 47 | 63 | 2,92 | – | 55,5 | 74,5 | 2,27 | – |
| 3 | 6 | 1050 | $O_2$ | 50 | 70 | 2,73 | 32 | 54 | 75 | 1,61 | 22 |
| 4 | 2 | 1100 | $O_2$ | 39 | 60 | 2,72 | – | 49,5 | 76 | 1,43 | – |
| 5 | 4 | 1100 | $O_2$ | 46 | 62 | 2,91 | – | 64,5 | 76 | 1,34 | – |
| 6 | 6 | 1100 | $O_2$ | 50 | 72,5 | 2,89 | 26 | 59 | 81,5 | 0,90 | 10 |
| 7 | 8 | 1100 | $O_2$ | 49 | 62 | 2,96 | 44 | 68 | 75 | 1,23 | 24 |

In der nachfolgenden Tabelle 3 ist dargestellt, wie ein Temperprozeß in Sauerstoff $O_2$ bei Temperaturen im Bereich von 200 bis 1100 °C und über eine Dauer von 2 h sich auf die Werte für die optische Transparenz im Wellenlängenbereich von 633 bis 800 nm und für die Spannung bei SiC-Membranen auswirkt, in die Borionen mit einer Dosis von $10^{15}$/cm² bei einer Implantationsenergie im Bereich von 150 bis 400 keV implantiert wurden. Mit steigender Temperatur verbessern sich die Werte für die Transparenz auf bis zu 70 %, wobei die Werte für die Spannung sich in einem tolerierbaren Rahmen halten.

Tabelle 3: Thermische Oxidation von SiC-Membranen, in die Borionen einer Dosis von $10^{15}/cm^2$ implantiert wurden

| Probe Nr. | Temperung | | | Eigenschaften vor der Temperung | | | Eigenschaften nach der Temperung | | |
|---|---|---|---|---|---|---|---|---|---|
| | Dauer [h] | Temp. [°C] | Atmosphäre | Transparenz [%] λ = 633 nm | Transparenz [%] λ = 800 nm | Spannung [x $10^7$ N/m$^2$] | Transparenz [%] λ = 633 nm | Transparenz [%] λ = 800 nm | Spannung [x $10^7$ N/m$^2$] |
| 11 | 2 | 200 | O$_2$ | 15 | 29 | 7,1 | 16 | 33 | 8,3 |
| 13 | 2 | 1100 | O$_2$ | 19 | 32 | 5,2 | 49 | 70 | 16 |

Es kann so verfahren werden, daß das Silicium-Einkristallsubstrat 1 allseitig mit einer SiC-Schicht 3 versehen wird, wonach sich die Prozeßschritte zur Entfernung des Silicium-Einkristallsubstrates 1 im Membranbereich 5 und die Ausbildung der Oxidschicht 7 auf der SiC-Schicht 3 und freiliegenden Bereichen des Silicium-Einkristallsubstrates 1 anschließen. Es kann jedoch auch so verfahren werden, daß das Silicium-Einkristallsubstrat 1 nach Anbringen der SiC-Schicht 3 zunächst zur Ausbildung der Oxidschicht 7 oxidiert wird, wonach im Membranbereich 5 die Silicium-Einkristallscheibe 1 mit den auf diesem Substratteil angebrachten Schichten (SiC-Schicht 3 und Oxidschicht 7) durch einen selektiven Ätzprozeß entfernt wird.

Soll die Gitterstruktur der SiC-Schicht 3 durch Ionenbeschuß gestört werden, bevor die Oxidschicht 7 auf der SiC-Schicht 3 ausgebildet wird, kann so vorgegangen werden, daß das Silicium-Einkristallsubstrat 1 allseitig mit einer SiC-Schicht 3 versehen wird, daß anschließend der entsprechend der herzustellenden Membran im Membranbereich 5 liegende Mittelteil des Silicium-Einkristallsubstrats 1 mit der auf ihm befindlichen SiC-Schicht 3 durch einen selektiven Ätzprozeß entfernt wird und daß dann anschließend in die verbliebene

7

freigelegte SiC-Schicht 3, die bereits die Membran darstellt, die gewünschten Ionen implantiert werden. In diesem Fall kann die Ionenimplantation z.B. auch von der Rückseite der Membran her erfolgen.

Es kann auch so vorgegangen werden, daß die allseitig auf dem Silicium-Einkristallsubstrat 1 angebrachte SiC-Schicht 3 einem Ionenbeschuß ausgesetzt wird, bevor der selektive Ätzprozeß zur Entfernung des Silicium-Einkristallsubstrates 1 im Membranbereich 5 vorgenommen wird.

Es kann auch so vorgegangen werden, daß das Silicium-Einkristallsubstrat 1 nur an einer seiner Hauptflächen mit einer SiC-Schicht 3 versehen wird und nach Implantation der gewünschten Ionen eine Ätzmaske (lose aufgelegt oder aus der Gasphase abgeschieden) auf der nicht mit SiC beschichteten Hauptfläche des Silicium-Einkristallsubstrates 1 angebracht wird, wonach das Silicium-Einkristallsubstrat 1 im Membranbereich 5 durch einen selektiven Ätzprozeß entfernt wird.

In die SiC-Schicht 3 können Bor-, Kohlenstoff- Stickstoff-, Silicium- oder Wasserstoff-Ionen implantiert werden. Die Implantationsdaten sind im Rahmen des vorliegenden Verfahrens vom Fachmann im Bereich der gewünschten Spannungsreduzierung ohne Schwierigkeiten zu ermitteln.

## Patentansprüche

1. Verfahren zur Herstellung eines Maskenträgers (Membran) aus SiC für Strahlungslithographie-Masken, wobei eine SiC-Schicht mindestens auf einer der beiden Hauptflächen eines Substrates in Form einer Silicium-Einkristallscheibe abgeschieden und die Silicium-Einkristallscheibe bis auf einen Randbereich mittels eines selektiven Ätzschrittes entfernt wird,
   dadurch gekennzeichnet,
   daß der Maskenträger vor oder nach dem selektiven Ätzschritt in oxidierender Atmosphäre bei einer Temperatur im Bereich von 200 bis 1350 °C über eine Dauer von 2 bis 10 h getempert wird.

2. Verfahren nach Anspruch 1,
   dadurch gekennzeichnet,
   daß der Maskenträger unter Sauerstoff-Atmosphäre bei einer Temperatur von 1100 °C über eine Dauer von 4 h getempert wird.

3. Verfahren nach den Ansprüchen 1 und 2,
   dadurch gekennzeichnet,
   daß der Temperprozeß nur in ausgewählten Bereichen der SiC-Schicht mittels Erhitzung dieser Bereiche durch Laserstrahlung unter oxidierender Atmosphäre durchgeführt wird.

4. Verfahren nach mindestens einem der Ansprüche 1 bis 3,
   dadurch gekennzeichnet,
   daß die SiC-Schicht mittels Chemical Vapour Deposition (CVD) auf dem Substrat abgeschieden wird.

5. Verfahren nach Anspruch 4,
   dadurch gekennzeichnet,
   daß die Silicium-Einkristallscheibe in der für den Abscheidungsprozeß vorgesehenen Vorrichtung zunächst auf eine Temperatur im Bereich von 1000 bis 1350 °C unter einer $H_2$-Atmosphäre aufgeheizt, danach mit einem geeigneten Ätzmittel angeätzt, danach unter Einwirkung von $H_2$ gespült und anschließend die SiC-Schicht aus einer Silicium und Kohlenwasserstoffe enthaltenden Gasatmosphäre angebracht und das beschichtete Substrat auf Raumtemperatur unter $H_2$-Atmosphäre abgekühlt wird.

6. Verfahren nach Anspruch 5,
   dadurch gekennzeichnet,
   daß die Silicium-Einkristallscheibe vor Abscheidung der SiC-Schicht auf eine Temperatur von 1100 °C aufgeheizt wird.

7. Verfahren nach Anspruch 6,
   dadurch gekennzeichnet,
   daß auf der Silicium-Einkristallscheibe unter Einwirkung eines Kohlenwasserstoffgases eine SiC-Keimschicht erzeugt wird.

8. Verfahren nach Anspruch 6,
   dadurch gekennzeichnet,

daß als Reaktionsgas zur Abscheidung der SiC-Schicht 0,05 bis 8,0 %, vorzugsweise 1,4 % Dichlordimethylsilan $(CH_3)_2SiCl_2$ in Wasserstoff $H_2$, zuzüglich 15 % Propan $C_3H_8$, bezogen auf Dichlordimethylsilan, eingesetzt wird.

9. Verfahren nach Anspruch 6,
   dadurch gekennzeichnet,
   daß als Reaktionsgas zur Abscheidung der SiC-Schicht Silan $SiH_4$ mit Toluol $C_7H_8$ eingesetzt wird.

10. Verfahren nach Anspruch 6,
    dadurch gekennzeichnet,
    daß als Reaktionsgas zur Abscheidung der SiC-Schicht Silan $SiH_4$ mit Propan $C_3H_8$ eingesetzt wird.

11. Verfahren nach mindestens einem der Ansprüche 1 bis 10,
    dadurch gekennzeichnet,
    daß die SiC-Schicht mit einer Dicke im Bereich von 1,5 bis 3,0 $\mu$m abgeschieden wird.

12. Verfahren nach mindestens einem der Ansprüche 1 bis 11,
    dadurch gekennzeichnet,
    daß auf der SiC-Schicht eine Oxidschicht mit einer Dicke im Bereich von 50 bis 200 nm ausgebildet wird.

13. Verfahren nach mindestens einem der Ansprüche 1 bis 12,
    dadurch gekennzeichnet,
    daß in die SiC-Schicht vor dem Tempern Ionen implantiert werden zur mechanischen Störung der Kristallstruktur der SiC-Schicht.

14. Verfahren nach Anspruch 13,
    dadurch gekennzeichnet,
    daß in die SiC-Schicht Borionen mit einer Dosis von $10^{15}$ bis $10^{16}/cm^2$ bei einer Implantationsenergie im Bereich von 150 bis 400 keV implantiert werden.

15. Verfahren nach Anspruch 13,
    dadurch gekennzeichnet,
    daß in die SiC-Schicht Kohlenstoffionen mit einer Dosis von $10^{15}$ bis $5.10^{16}/cm^2$ bei einer Implantionsenergie im Bereich von 150 bis 400 keV implantiert werden.

16. Verfahren nach Anspruch 13,
    dadurch gekennzeichnet,
    daß in die SiC-Schicht Stickstoffionen mit einer Dosis von $10^{15}$ bis $5.10^{16}/cm^2$ bei einer Implantationsenergie im Bereich von 150 bis 400 keV implantiert werden.

17. Verfahren nach mindenstens einem der Ansprüche 1 bis 16,
    dadurch gekennzeichnet,
    daß in [100]-Richtung orientierte Silicium-Einkristallscheiben als Substrat eingesetzt werden.

18. Verfahren nach mindestens einem der Ansprüche 1 bis 16,
    dadurch gekennzeichnet,
    daß in [111]-Richtung orientierte Silicium-Einkristallscheiben als Substrat eingesetzt werden.

## Claims

1. A method of manufacturing a mask support (diaphragm) of SiC for radiation lithography masks, in which an SiC layer is deposited at least on one or the two major surfaces of a substrate in the form of a silicon single crystal wafer and the silicon single crystal wafer is removed, except for an edge region, by means of a selective etching step, characterized in that the mask support is annealed, before or after the selective etching step, in an oxidizing atmosphere at a temperature in the range of 200 to 1350°C for a duration of 2 to 10 h.

2. A method as claimed in Claim 1, characterized in that the mask support is annealed in an oxygen atmosphere at a temperature of 1100°C for a duration or 4 h.

3. A method as claimed in Claims 1 and 2, <u>characterized in that</u> the annealing process is carried out only in selected regions of the SiC layer by means of heating of these regions through laser radiation in an oxidizing atmosphere.

4. A method as claimed in at least one of Claims 1 to 3, <u>characterized in that</u> the SiC layer is deposited on the substrate by means of chemical vapour deposition (CVD).

5. A method as claimed in Claim 4, <u>characterized in that</u> the silicon single crystal wafer is first heated to a temperature in the range of 1000 to 1350°C in an atmosphere of $H_2$ in the arrangement used for the deposition process, is then etched by a suitable etchant and is subsequently flushed under the action of $H_2$, whereupon the SiC layer is provided from an atmosphere containing silicon and hydrocarbons and the coated substrate is cooled down to room temperature in an atmosphere of $H_2$.

6. A method as claimed in Claim 5, <u>characterized in that</u> the silicon single crystal wafer is heated to a temperature of 1100°C before the deposition of the SiC layer.

7. A method as claimed in Claim 6, <u>characterized in that</u> an SiC nucleation layer is formed on the silicon single crystal wafer under the action of a hydrocarbon gas.

8. A method as claimed in Claim 6, <u>characterized in that</u> 0.05 to 8.0%, preferably 1.4% of dichlorodimethyl silane $(CH_3)_2SiCl_2$ in hydrogen $H_2$ plus 15% of propane $C_3H_8$ in relation to dichlorodimethylsilane, is used as a reaction gas for depositing the SiC layer.

9. A method as claimed in Claim 6, <u>characterized in that</u> silane $SiH_4$ with toluene $C_7H_8$ is used as a reaction gas for depositing the SiC layer.

10. A method as claimed in Claim 6, <u>characterized in that</u> silane $SiH_4$ with propane $C_3H_8$ is used as a reaction gas for deposition the SiC layer.

11. A method as claimed in at least one of Claim 1 to 10, <u>characterized in that</u> the SiC layer is deposited to a thickness of 1.5 to 3.0 µm.

12. A method as claimed in at least one of Claim 1 to 11, <u>characterized in that</u> an oxide layer having a thickness in the range of 50 to 200 nm is formed in the SiC layer.

13. A method as claimed in at least one of Claim 1 to 12, <u>characterized in that</u> before the annealing step ions are implanted into the SiC layer for mechanically disturbing the crystal structure of the SiC layer.

14. A method as claimed in Claim 13, <u>characterized in that</u> boron ions are implanted into the SiC layer at a dose of $10^{15}$ to $10^{16}/cm^2$ at an implantation energy in the range of 150 to 400 keV.

15. A method as claimed in Claim 13, <u>characterized in that</u> carbon ions are implanted into the SiC layer at a dos of $10^{15}$ to $5.10^{16}/cm^2$ at an implantation energy in the range of 150 to 400 keV.

16. A method as claimed in Claim 13, <u>characterized in that</u> nitrogen ions are implanted into the SiC layer at a dos of $10^{15}$ to $5.10^{16}/cm^2$ at an implantation energy in the range of 150 to 400 keV.

17. A method as claimed in at least one of Claim 1 to 16, <u>characterized in that</u> silicon single crystal wafers oriented in [100] direction are used as the substrate.

18. A method as claimed in at least one of Claim 1 to 16, <u>characterized in that</u> single crystal wafers oriented in [111] direction are used as the substrate.

**Revendications**

1. Procédé pour la fabrication d'un support de masque (membrane) en SiC pour masques destinés à la lithographie par rayonnement, procédé dans lequel une couche de SiC est déposée au moins sur l'une des deux faces principales d'un substrat sous la forme d'un disque à monocristal de silicium et dans lequel le disque à monocristal de silicium est, à l'exception d'une zone marginale, ensuite enlevé par le biais d'une étape de morsure sélective, caractérisé en ce que, avant ou après l'étape de morsure sélective, le support de masque est recuit dans une atmosphère oxydante à une température dans la plage de 200 à 1350°C et durant une période de 2 à 10 heures.

2.  Procédé suivant la revendication 1, caractérisé en ce que le support de masque est recuit sous atmosphère d'oxygène à une température de 1100°C durant une période de 4 heures.

3.  Procédé suivant les revendications 1 et 2, caractérisé en ce que le processus de recuisson n'est appliqué qu'en des zones choisies de la couche SiC par chauffage de ces zones au moyen de rayons laser en atmosphère oxydante.

4.  Procédé suivant l'une quelconque des revendications 1 à 3, caractérisé en ce que la couche de SiC est déposée sur le substrat par le procédé de déposition en phase vapeur chimique (DVC).

5.  Procédé suivant la revendication 4, caractérisé en ce que le disque à monocristal de silicium dans le dispositif prévu pour le processus de dépôt est d'abord chauffé à une température dans la plage de 1000 à 1350°C en atmosphère de $H_2$, ensuite mordu au moyen d'un agent de morsure approprié, ensuite rincé sous l'action de $H_2$, et ensuite la couche de SiC déposée à partir d'une atmosphère gazeuse contenant du silicium et des hydrocarbures et le substrat recouvert ramené à la température ambiante en atmosphère de $H_2$.

6.  Procédé suivant la revendication 5, caractérisé en ce que le disque à monocristal de silicium est chauffé à une température de 1100°C avant le dépôt de la couche SiC.

7.  Procédé suivant la revendication 6, caractérisé en ce que sur le disque à monocristal de silicium est produite une couche de germination SiC sous l'effet d'un gaz hydrocarboné.

8.  Procédé suivant la revendication 6, caractérisé en ce qu'il est fait usage en tant que gaz réactionnel pour le dépôt de la couche de SiC de 0,05 à 8,0%, mais de préférence 1,4% de dichlorodiméthylsilane $(CH_3)_2SiCl_2$ dans de l'hydrogène $H_2$, additionné de 15% de propane $C_3H_8$, par rapport au dichlorodiméthylsilane.

9.  Procédé suivant la revendication 6, caractérisé en ce qu'il est fait usage de silane $SiH_4$ et du toluène $C_7H_8$ en tant que gaz réactionnel pour le dépôt de la couche de SiC.

10. Procédé suivant la revendication 6, caractérisé en ce qu'il est fait usage de silane $SiH_4$ et de propane $C_3H_8$ en tant que gaz réactionnel pour le dépôt de la couche de SiC.

11. Procédé suivant l'une quelconque des revendications 1 à 10, caractérisé en ce que la couche de SiC est déposée en une épaisseur comprise dans une plage de 1,5 à 3,0 $\mu$m.

12. Procédé suivant l'une quelconque des revendications 1 à 11, caractérisé en ce qu'une couche d'oxyde d'une épaisseur comprise dans une plage de 50 à 200 nm est formée sur la couche de SiC.

13. Procédé suivant l'une quelconque des revendications 1 à 12, caractérisé en ce qu'avant la recuisson, des ions sont implantés dans la couche de SiC en vue de la perturbation mécanique de la structure cristalline de la couche de SiC.

14. Procédé suivant la revendication 13, caractérisé en ce que dans la couche de SiC, sont implantés des ions bore en une dose de $10^{15}$ à $10^{16}$/cm$^2$ sous une énergie d'implantation de l'ordre de 150 à 400 keV.

15. Procédé suivant la revendication 13, caractérisé en ce que dans la couche de SiC, sont implantés des ions carbone en une dose de $10^{15}$ à $5.10^{16}$/cm$^2$ sous une énergie d'implantation de l'ordre de 150 à 400 keV.

16. Procédé suivant la revendication 13, caractérisé en ce que dans la couche de SiC, sont implantés des ions azote en une dose de $10^{15}$ à $5.10^{16}$/cm$^2$ sous une énergie d'implantation de l'ordre de 150 à 400 keV.

17. Procédé suivant l'une quelconque des revendications 1 à 16, caractérisé en ce que sont utilisés, en tant que substrat, des disques à monocristal de silicium orientés en direction [100].

18. Procédé suivant l'une quelconque des revendications 1 à 16, caractérisé en ce que sont utilisés, en tant que substrat, des disques à monocristal de silicium orientés en direction [111].

Fig.1